# EUROPEAN PATENT SPECIFICATION

(11) **EP 4 266 064 B1**
(45) Date of publication and mention of the grant of the patent: **24.09.2025**
(21) Application number: 22169559.6
(22) Date of filing: 22.04.2022
(51) Int. Cl.: G01R 22/06

(54) **METERING DEVICE**
ZÄHLEREINRICHTUNG
DISPOSITIF DE MESURE

(43) Date of publication of application: 25.10.2023
(73) Proprietor: ABB Schweiz AG, 5400 Baden (CH)
(72) Inventor: IAPICHELLA, Rosario, 21050 Cairate (IT)
(74) Representative: De Bortoli, Eros

(56) References cited:
- CN-A- 113 311 202
- CN-U- 215 728 365
- KR-B1- 101 919 369

## Description

The present invention relates to a metering device for low-voltage electric systems.

Metering devices are widely used to measure and monitor electric quantities (e.g. electric power) delivered to electric loads. As is known, these devices are subject to regulations (for example the well-known MID standards), which require them to be equipped with tamperproof terminal covers configured to prevent the access to the electric terminals and intended to be sealed, once the installation is completed.

In more traditional metering devices of the state of the art, these terminal covers are provided as accessory parts to be mounted on the metering device. The spare components need to be manufactured separately and packaged together with the metering device, which makes the manufacturing process of this latter more time consuming. Additionally, they are generally difficult to handle and can be easily lost during installation. Furthermore, they are often bulky and can remarkably increase the overall size of the metering device, even making difficult the installation of other devices in proximity of the metering device.

According to other solutions of the state of the art, for example the one disclosed in KR1575217B1, the terminal covers of the metering device are hinged to the insulating housing and are rotatably movable between an open position and closed position, at which they do not cover / cover the corresponding electric terminals of the metering device. A further similar prior art solution is disclosed in CN215728365U.

In general, the solutions of this type still entail an increase of the size of the metering device. Additionally, it has been seen that these rotating terminal covers can interfere with cabling operations, when they are in an open position. In some cases, particularly when the metering device is installed in an electric switchboard, the front panel of the metering device can prevent the terminal covers to be unsealed and re-opened when necessary, therefore making possible maintenance interventions on the metering device more difficult.

In further solutions of the state of the art, the movable terminal covers of the metering device are slidingly coupled to the insulating housing. The experience has shown that these solutions can often make the cabling operations less comfortable. The terminal covers generally need to be hold manually in the open position and, in some cases, they can partially hide the cabling holes of the metering device, particularly when this latter is installed on a DIN rail.

In view of the above, it is apparent how, in the state of the art, it is still quite felt the need for metering devices employing innovative solutions capable of overcoming or mitigating the above-mentioned criticalities of the currently available traditional devices.

In order to respond to this need, the present invention provides a metering device according to the following claim 1 and the related dependent claims.

In a general definition, the metering device of the invention comprises:
- an insulating housing defining an internal volume of said metering device;
- one or more groups of electric terminals accommodated in the internal volume of said metering device, each electric terminal being configured to be electrically and mechanically connected with a corresponding cable of an electric line.

The insulating housing comprises, for at least a group of electric terminals, a group of cabling holes, each of which is configured to form a passage for corresponding cables of an electric line.

The insulating housing comprises, for at least a group of electric terminals, a first wall portion and a second wall portion mutually adjacent and unparallel one to another.

The insulating housing comprises, for at least a group of electric terminals, a group of access holes arranged at the corresponding second wall portion. Said access holes are configured to allow an access to corresponding electric terminals of the metering device.

According to the invention, the metering device comprises, for at least a group of electric terminals, a movable cover mechanically coupled to said insulating housing. Such a cover is movable between a first position, at which said cover is located at said first wall portion, and a second position, at which said cover is located at said second wall portion.

Each cover of the metering device obstructs the corresponding access holes of said insulating housing, when it is in said second position.

Each cover of the metering device makes rotation and translation movements relative to said insulating housing, when said cover is moved between said first position and said second position.

Preferably, each cover of the metering device passes through an intermediate position, when said cover is moved between said first position and said second position.

In particular, each cover of the metering device makes a rotation movement, when said cover is moved between said first position and said intermediate position, and makes a translation movement, when said cover is moved between said intermediate position and said second position.

According to the invention, each cover of the metering device is accommodated in a first seat of the corresponding first wall portion of the insulating housing, when said cover is in said first position.

Preferably, each cover of the metering device is coplanar with an outer surface of the corresponding first wall portion of the insulating housing, when said cover is accommodated in the corresponding first seat.

Preferably, each cover of the metering device is accommodated in a second seat of the corresponding second wall portion of the insulating housing, when said cover is in said second position.

Preferably, each cover of the metering device is buried in the internal volume defined by the insulating housing, when said cover is accommodated in the corresponding second seat.

Preferably, each cover of the metering device comprises first holding means configured to interact mechanically with corresponding second holding means of said insulating housing to hold said cover in said first position. Said first holding means are configured to couple with said second holding means, when said cover reaches said first position. Said first holding means are configured to decouple from said second holding means, when said cover is moved away from said first position.

Preferably, each cover of the metering device comprises first hinging means configured to interact mechanically with corresponding second hinging means of said insulating housing to hinge said cover to said insulating housing, when said cover is moved rotationally between said first position and said intermediate position. Said first hinging means are configured to couple with said second hinging means, when said cover is translationally moved away from said second position and reaches said intermediate position. Said first hinging means are configured to decouple from said second hinging means, when said cover is translationally moved away from said intermediate position towards said second position.

Preferably, said first hinging means are configured to interact mechanically with corresponding third holding means of said insulating housing to hold said cover in said second position. Said first hinging means are configured to couple with said third holding means, when said cover reaches said second position. Said first hinging means are configured to decouple from said third holding means, when said cover is moved away from said second position.

Preferably, each cover of the metering device comprises first coupling means configured to couple with corresponding second coupling means of said insulating housing, when said cover is in said second position. Said first and second coupling means are configured to cooperate mechanically with suitable fixing means to seal said cover in said second position, when said cover is in said second position.

Further characteristics and advantages of the invention will become apparent from the detailed description of exemplary embodiments, which are illustrated only by way of non-limitative examples in the accompanying drawings, wherein
Figures 1-2 schematically show the metering device, according to the invention;
Figures 3-8 schematically show some details of the metering device, according to the invention.

With reference to the cited figures, the present invention relates to a metering device 1 for low-voltage electric systems, i.e. operating at voltage levels lower than 1 kV AC and 1.5 kV DC. The metering device of the invention is particularly adapted for operating as an energy meter. In principle, however, it may be configured for measuring other electric quantities.

The metering device of the invention can be conveniently installed in low-voltage switchboards or electric lines. In these cases, for example, it can be mounted on a DIN rail or another support of similar type. In further applications, the metering device of the invention can be enclosed in suitable devices or installations.

Referring to the cited figures, the metering device 1 comprises an insulating housing 2 defining an internal volume of the metering device. The insulating housing 2 is conveniently made of an electrically insulating plastic material, for example a thermosetting or thermoplastic material.

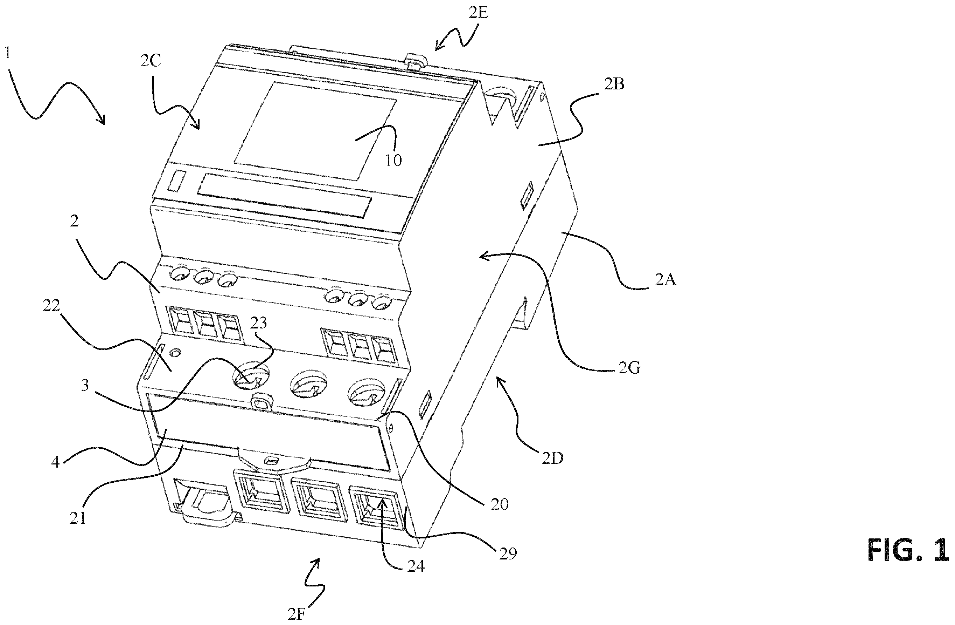

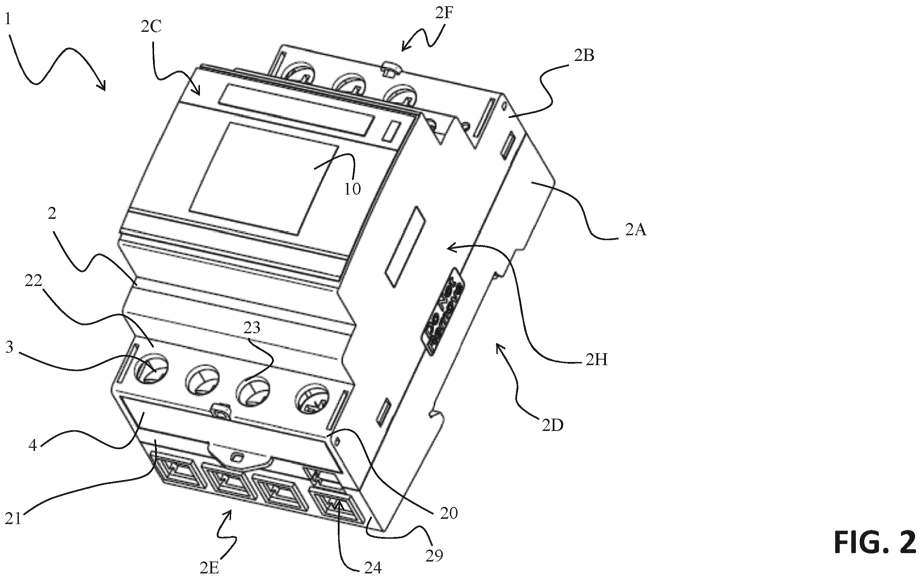

The insulating housing 2 has generally a cuboid shape with pairs of opposite sides. In particular, the insulating housing has, as shown in figures 1-2, opposite front and rear sides 2C, 2D, opposite top and bottom sides 2E, 2F and opposite flank sides 2G, 2H (reference is made to a normal installation position of the metering device, for example on a DIN rail). Preferably, the insulating housing 2 comprises a base portion 2A and a cover portion 2B, which can be mutually joined in a known manner, e.g. by means of screws or snap-fit arrangements. Preferably, as shown in the cited figures, the metering device 1 comprises a display 10 at the front side 2C of the insulating housing. Other interface arrangements, for example buttons, micro-switches or the like, may be arranged according to the needs.

The metering device 1 comprises one or more groups of electric terminals 3 accommodated in the internal volume defined by the insulating housing 2. Each electric terminal 3 is configured to be electrically and mechanically connected with a corresponding cable of an electric line. Normally, the metering device 1 comprises two groups of electric terminals 3, one electrically connectable to an equivalent electric source and the other electrically connectable to an equivalent electric load.

In the following, for the sake of brevity and without intending to limit the scope of the invention, the metering device 1 will be described with particular reference to embodiments of the invention employing this solution. According to other embodiments of the invention, however, the metering device may include a single group of electric terminals 3 or three or more groups of electric terminals 3, according to the needs.

In the embodiment shown in the cited figures, the different groups of electric terminals 3 are arranged in proximity of opposite sides of the insulating housing, namely at the opposite top and bottom sides 2E, 2F. Obviously, a different positioning of the electric terminals is possible, according to the needs.

The number of electric terminals included in each group of electric terminals may vary according to the needs. Additionally, different groups of electric terminals may have different numbers of electric terminals.

In general, the electric terminals 3 may be realized at industrial level according to solutions of known type. Thus, in the following, they will not be described in further details for the sake of brevity.

In order to allow cabling of the metering device, the insulating housing 2 comprises, for at least a group of electric terminals, a corresponding group of cabling holes 24. Each cabling hole 24 is configured to form a passage for a corresponding cable of an electric line.

In the embodiment shown in the cited figures, the cabling holes 24 are arranged at opposite sides of the insulating housing 2, namely at the top and bottom sides 2E, 2F. Obviously, a different positioning of the cabling holes 24 is possible, according to the needs.

The number of cabling holes 24 included in each group of cabling holes may vary according to the needs, basically depending on the number of electric terminals 3 included in the corresponding group of electric terminals. Obviously, different groups of cabling holes may have different numbers of cabling holes.

In the embodiment shown in the cited figures, two different groups of four cabling holes 24 are arranged at the opposite top and bottom sides 2E, 2F of the insulating housing. Conveniently, the layout of the cabling holes 24 is designed depending on the layout of the corresponding electric terminals 3. As an example, in the embodiment shown in the cited figures, the cabling holes 24 of each group of cabling holes are mutually aligned.

Each group of cabling holes 24 is conveniently arranged at a corresponding wall portion 29 of the insulating housing. In the embodiment shown in the cited figures, each wall portion 29 is included in the base portion 2A of the insulating housing.

The insulating housing 2 comprises, for at least a group of electric terminals, a first wall portion 21 and a second wall portion 22.

The first and second wall portions 21, 22 are mutually adjacent. Therefore, they have a wall edge 20 in common. Further, the first and second wall portions 21, 22 are mutually unparallel. They thus extend along corresponding intersecting planes. The intersection axis between these intersecting planes is located at the common wall edge 20 of the first and second walls.

Preferably, as shown in the cited figures, the first and second wall portions 21, 22 are mutually perpendicular one to another. In this case, the common wall edge 20 forms the corner between the first and second wall portions 21, 22. In principle, however, the first and second wall portions 21, 22 may be angled differently. As an example, the intersecting planes of these wall portions may form an angle between 90° and 150°.

In the embodiment shown in the cited figures, each first wall portion 21 is conveniently coplanar with a corresponding wall portion 29 including the cabling holes 24. According to other embodiments, however, each first wall portion 21 and the corresponding wall portion 29 may extend along different planes, for example along different parallel planes.

Preferably, each pair of wall portions 21, 22 is arranged at different adjacent sides of the insulating housing. In the embodiment shown in the cited figures, each first wall portion 21 is located at the top side 2E or at the bottom side 2F of the insulating housing while each second wall portion 22 is located at the front side 2C of the insulating housing, in proximity of the top side 2E or bottom side 2F.

For at least a group of electric terminals, the insulating housing 2 comprises a group of access holes 23 configured to allow an access to corresponding electric terminals 3. The access holes 23 are configured to allow an operator to insert a mechanical tool (e.g. a screwdriver) to connect or disconnect an electric cable from a corresponding electric terminal 3.

Each group of access holes 23 is arranged at a corresponding wall portion 22 of the insulating housing. In this way, they can be easily accessed by an operator.

The number of access holes 23 included in each group of access holes may vary according to needs, basically depending on the number of corresponding electric terminals 3 on which an operator can intervene. The number of access holes 23 can thus differ from the number of electric terminals 3 of the corresponding group of electric terminals. Obviously, different groups of access holes may have different numbers of access holes.

In the embodiment shown in the cited figures, a group of three access holes 23 and a group of four access holes are arranged at corresponding wall portions 22 at the front side 2C of the insulating housing, respectively in proximity of the bottom side 2F and top side 2E. Conveniently, the layout of the access holes 23 is designed depending on the layout of the corresponding electric terminals. As an example, in the embodiments shown in the cited figures, the access holes 23 of each group of access holes are mutually aligned.

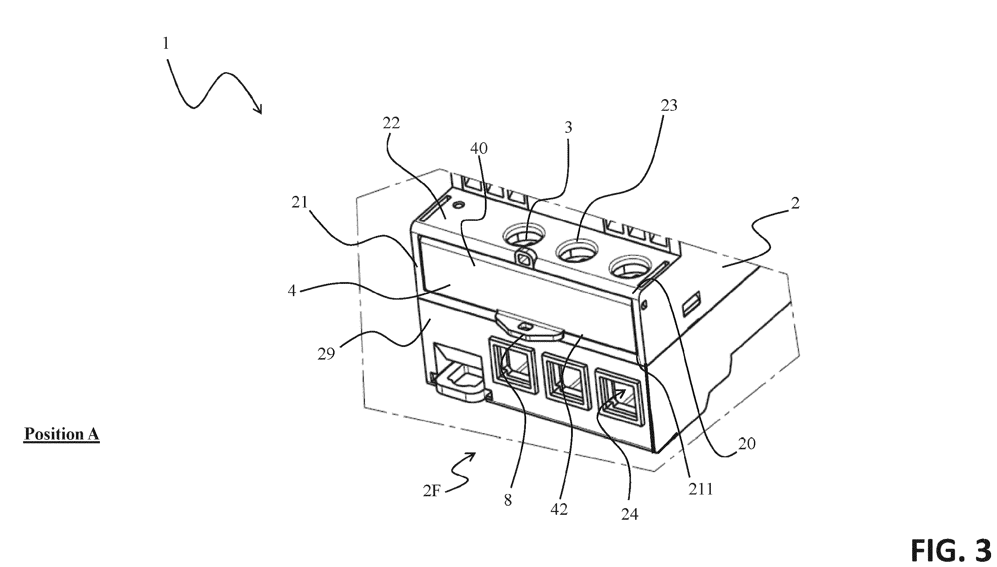

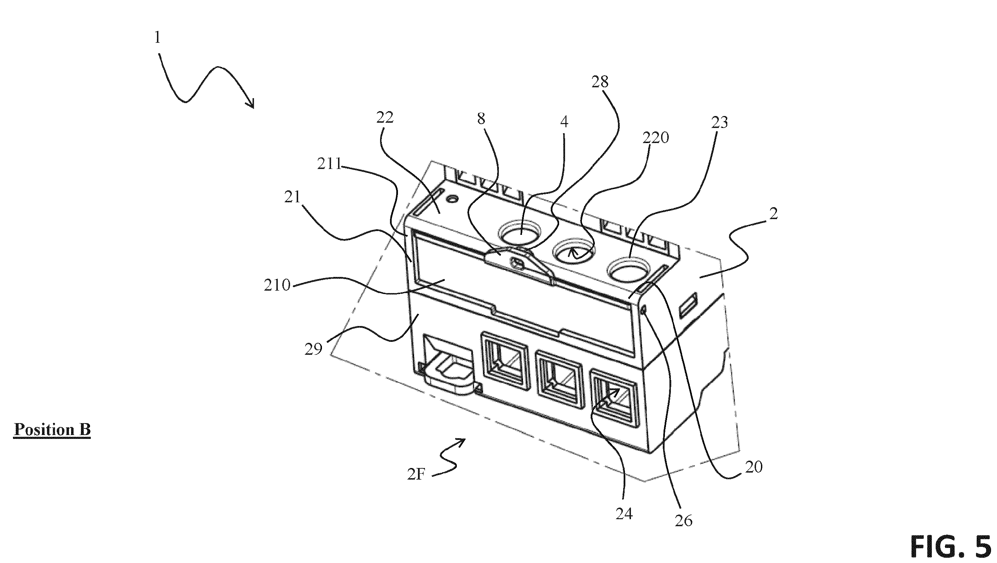

An essential aspect of the invention consists in that the metering device 1 comprises, for at least a group of electric terminals, a movable cover 4 mechanically coupled to the insulating housing. Each cover 4 of the metering device is reversibly movable between a first position A (figure 3), at which it is located at a corresponding first wall portion 21 of the insulating housing, and a second position B (figure 5), at which it is located at a corresponding second wall portion 22 of the insulating housing.

When located in the second position B, each cover 4 obstructs the access holes 23 arranged at the corresponding second wall portion 22, thereby preventing the access to the electric terminals 3 operatively associated to said access holes.

Each cover 4 can be moved manually between the above-mentioned first and second positions A, B (figures 3-5), for example during the installation of the metering device or during a maintenance intervention thereon.

An important feature of the movable cover 4 consists in that each cover 4 is configured to make rotation and translation movements relative to the insulating housing 2, when it is moved between the above-mentioned first and second positions A, B (figures 3-5).

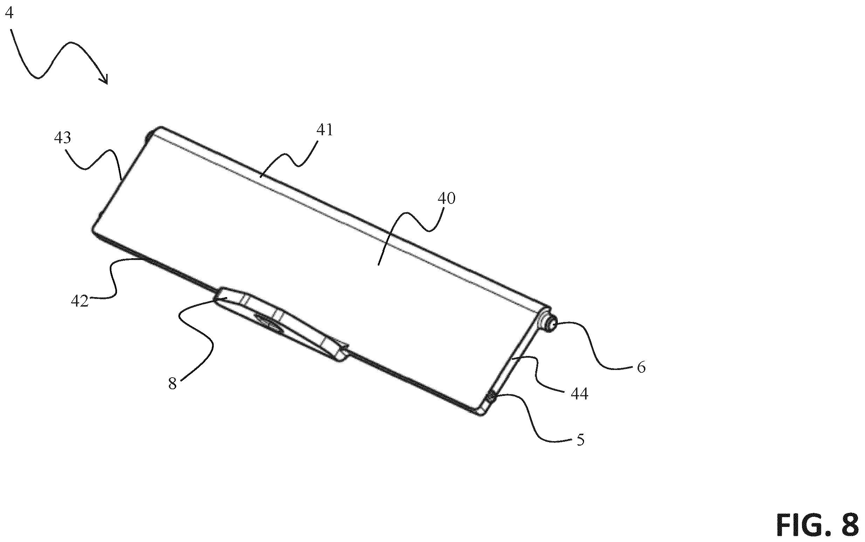

Figure 8 schematically shows a cover 4 of the metering device.

The cover 4 is preferably shaped as a plate having a shape that depend on the layout of access holes 23 on the corresponding second wall 22. In the embodiment shown in the cited figures, since the access holes 23 are aligned, the cover 4 is formed by a plate with an elongated shape extending along a main longitudinal direction, which is parallel to the alignment direction of the access holes 23. The cover 4 includes opposite first and second edges 41, 42 defining the longer longitudinal dimension and opposite third and fourth edges 43, 44 defining the shorter transversal dimension of the cover 4.

In the metering device, the number of covers 4 obviously depends on the number of groups of electric terminals 3 that need to be sealed when the metering device 1 operates. In the embodiment shown in the cited figures, the metering device 1 comprises a pair of covers 4 arranged in proximity of the bottom side 2F and top side 2E of the insulating housing, each operatively associated to a corresponding pair of wall portions 21, 22.

In the following, for the sake of brevity and without intending to limit the scope of the invention, features and operation of the one or more covers 4 of the metering device will be described with reference to a cover arranged in proximity of the bottom side 2F of the insulating housing. The same considerations obviously apply to the cover arranged in proximity of the top side 2E of the insulating housing and, more generally, to any other cover of the metering device.

Figures 3-5 schematically show the operation of the cover 4.

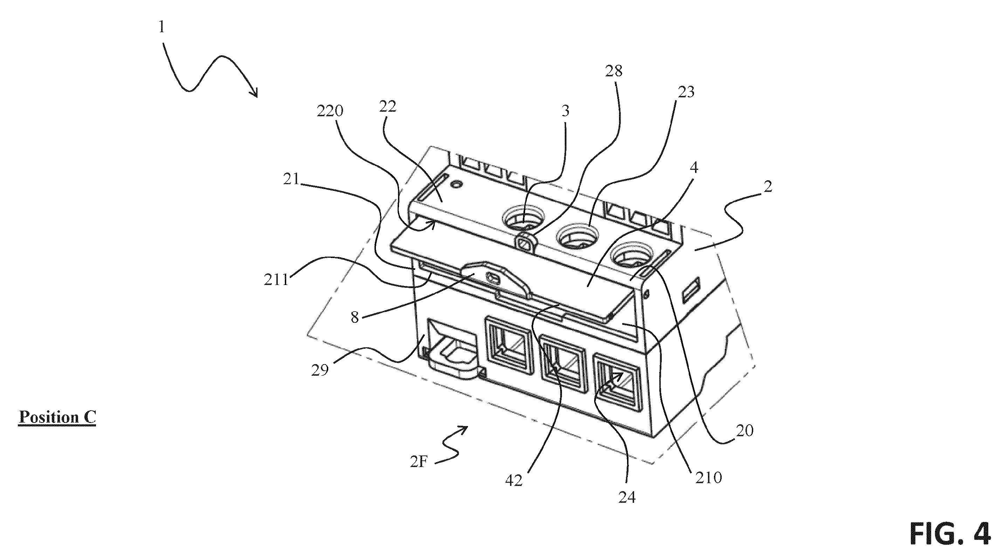

The cover 4 passes through an intermediate position C (figure 4), when it is reversibly moved between the first position A (figure 3) and second position B (figure 5).

The cover 4 is configured to make rotation movements, when it is reversibly moved between the first position A and the intermediate position C (figures 3-4), and it is configured to make translation movements, when it is reversibly moved between the intermediate position C and the second position B (figures 4-5).

Preferably, when it is in the first position A, the cover 4 is accommodated in a first seat 210 of the first wall portion 21 (figure 3).

Advantageously, the first seat 210 is formed by a groove arranged at an outer surface 211 (i.e. the surface oriented towards the surrounding environment) of the first wall portion 21 (figures 4-5) and having a shape fitting to the shape of the cover 4.

Preferably, when it is accommodated the first seat 210, the cover 4 has an outer surface 40 (i.e. the surface oriented towards the surrounding environment) coplanar with the outer surface 211 of the first wall portion 21 (figure 3).

This solution is quite advantageous as the cover 4 does not increase of the overall size of the metering device, when it is in the first position A. Additionally, being embedded in the insulating housing, the cover 4 cannot be an obstacle to possible cabling operations. According to an aspect of the invention, the cover 4 comprises first holding means 5 configured to interact mechanically with second holding means 25 of the insulating housing 2 to hold the cover 4 in the first position A. The first holding means 5 are configured to couple with the second holding means 25, when the cover 4 reaches the first position A, and are configured to decouple from the second holding means 25, when the cover 4 is moved away from the first position A (figures 4, 6 and 8).

In the embodiment shown in the cited figures, the first holding means are formed by first protrusions 5 at the opposite third and fourth transversal edges 43, 44 of the cover 4 while the second holding means are formed by first holes 25 at opposite edges of the first seat 210, which face the transversal edges 43, 44 of the cover 4, when the cover is in the first position A.

The first protrusions 25 couple to the first holes 25, when the cover 4 is moved to the first position A, and can easily decouple from the first holes 25, when the cover 4 is moved away from the first position A.

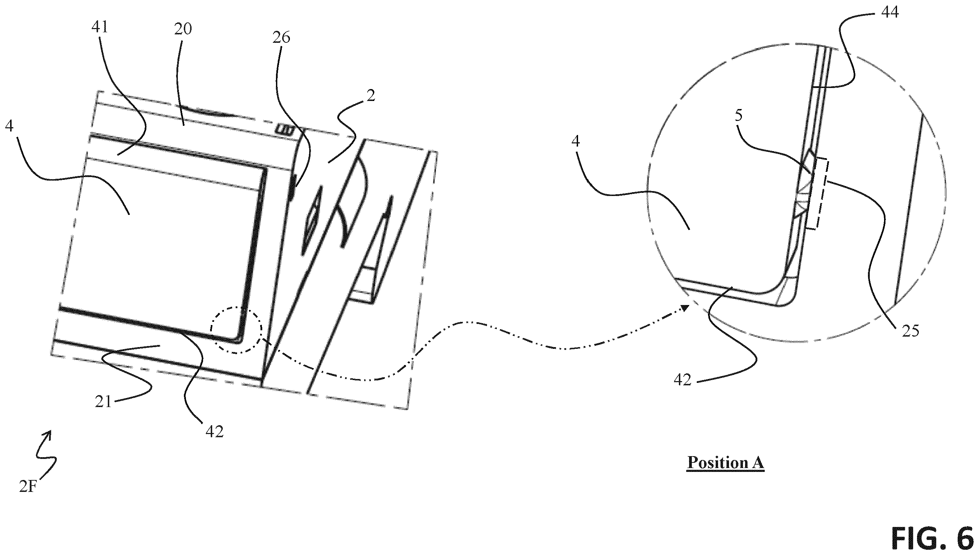

The first protrusions 5 and the first holes 25 are conveniently shaped so that they can fit together and hold the cover 4 in the first position A, when they are mutually coupled (figure 6), and they can be easily engaged or disengaged, when an operator exerts a manual force to move the cover. The first and second holding means 5, 25 may however be arranged differently from the solution proposed in the cited figures. For example, they may be positioned differently along the edges of the cover 4 and the seat 210. As an alternative, the first holding means 5 may be formed by a button protruding from an inner surface (not indicated) of the cover 4 (which is opposite to the outer surface 40) and the second holding means 25 by a corresponding hole at a bottom surface (not indicated) of the seat 210.

According to another aspect of the invention, the cover 4 comprises first hinging means 6 configured to interact mechanically with second hinging means 26 of the insulating housing 2 to hinge the cover 4 to the insulating housing, when the cover 4 is in the first position A or it is moved rotationally between the first position A and the intermediate position C (figures 4 and 8).

The first hinging means 6 are configured to couple with the second hinging means 26, when the cover 4 is translationally moved away from the second position B and reaches the intermediate position C, and they are configured to decouple from the second hinging means 26, when the cover 4 is translationally moved away from the intermediate position C towards the second position B.

Conveniently, the first and second hinging means 5, 26 are configured so that the cover 4 can rotate about a rotation axis parallel to the wall edge 20 in common between the wall portions 21, 22 of the insulating housing. Thus, the first longitudinal edge 41 of the cover 4 rotates about the rotation axis and the second edge 42 of the cover 4 is lifted or lowered, when the cover 4 is rotationally moved between the first position A and the intermediate position C.

In the embodiment shown in the cited figures, the first hinging means are formed by second protrusions 6 at the opposite third and fourth transversal edges 43, 44 of the cover 4 in proximity of the first longitudinal edge 41, which is preferably rounded to favor the rotation movement of the cover 4. The second hinging means are instead formed by second holes 26 at corresponding edges of the first seat 210, in proximity of the common wall edge 20.

The second protrusions 6 are coupled with the second holes 26 when the cover 4 is reversibly moved between the first position A and the intermediate position C. The second protrusions 6 couple to the second holes 26 when the cover 4 is moved away from the second position B and reaches the intermediate position C. The second protrusions 6 decouple from the second holes 26 when the cover 4 is moved away from the intermediate position C, towards the second position B.

The second protrusions 26 and the second holes 26 are conveniently shaped so that they can hinge the cover 4 to the insulating housing 2, when they are mutually coupled, and they can be easily engaged and disengaged, when an operator exerts a manual force to move the cover 4. The first and second hinging means 6, 26 may however be arranged differently from the solution proposed in the cited figures. For example, the first hinging means 6 may be formed by suitable holes obtained at the opposite third and fourth transversal edges 43, 44 of the cover 4 in proximity of the first longitudinal edge 41 whereas the second hinging means 26 may be formed by suitable protrusions at corresponding edges of the first seat 210, in proximity of the common wall edge 20.

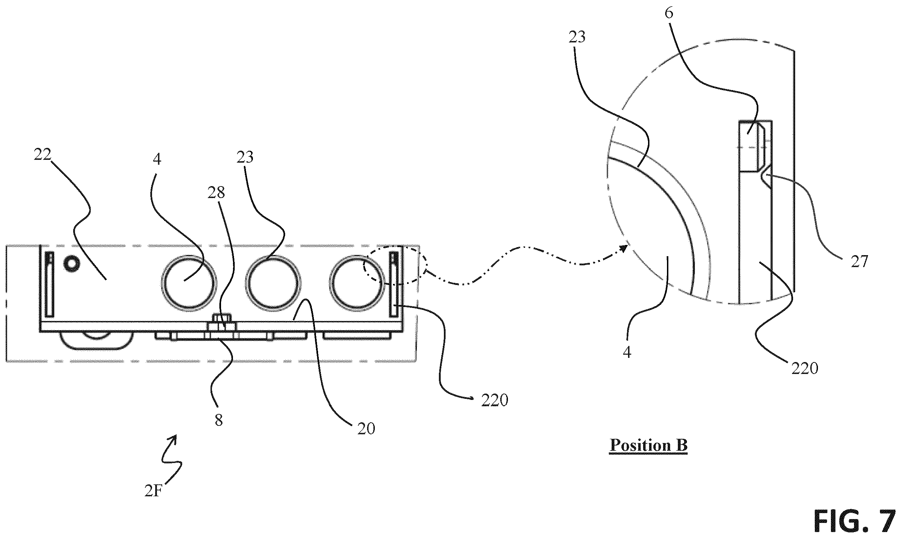

Preferably, when it is in the second position B, the cover 4 is accommodated in a second seat 220 of the second wall portion 22 (figures 5 and 7).

Advantageously, the second seat 220 is formed by a slot of the insulating housing 2 behind the second wall portion 22 and arranged in such a way that the cover can be inserted into it, when it is translationally moved towards or away from the second position B (figures 4 and 5).

The second seat 220 is conveniently in communication with the access holes 23 of the second wall portion 22, so that the cover 4 obstructs said access holes, when it is inserted into the slot 220 (figures 5 and 7).

Preferably, when it is accommodated in the second seat 220, the cover 4 is buried in the internal volume defined by the insulating housing 2. In practice, only a small protrusion 8 of the cover 4 sticks out of the insulating housing, when the cover is inserted in the slot 220.

According to another aspect of the invention, the first hinging means 6 of the cover 4 are configured to interact mechanically with third holding means 27 of the insulating housing to hold the cover 4 in the second position B (figures 7 and 8).

The first hinging means 6 are configured to couple with the third holding means 27, when the cover 4 reaches the second position B, and they are configured to decouple from the third holding means 27, when the cover 4 is moved away from the second position B.

In the embodiment shown in the cited figures, the third holding means are formed by third protrusions 27 at opposite edges of the second seat 220, which face the third and fourth transversal edges 43, 44 of the cover 4 when the cover is in the second position B.

The second protrusions 6 and the third protrusions 27 are conveniently shaped so that they can fit together and hold the cover 4 in the second position B, when they are mutually coupled (figure 7), and they can be easily engaged or disengaged, when an operator exerts a manual force to move the cover.

The third holding means 27 may however be arranged differently from the solution proposed in the cited figures. For example, the third holding means 27 may be formed by suitable holes or grooves at the opposite edges of the second seat 220, along which the third and fourth transversal edges 43, 44 of the cover 4 slide when the cover is moved translationally towards or away from the second position B.

The above-illustrated aspects of the invention are particularly advantageous.

The first and second holding means 5, 25 allow an operator to carry out the cabling operations without the need of holding manually the cover 4 in the first position A and without being hindered by the presence of the cover.

The first and second hinging means 6, 26 allow the cover 4 to be structurally integrated with the insulating housing 2 when it is reversibly moved between the first and second wall portions 21, 22.

The first hinging means 6 and the third holding means 27 allow an operator to carry out the sealing operations of the cover 4 without the need of holding manually this latter in the second position B.

According to an aspect of the invention, the cover 4 comprises first coupling means 8 configured to couple with second coupling means 28 of the insulating housing, when the cover 4 is in the second position B. The first and second coupling means 8, 28 are configured to cooperate mechanically with suitable fixing means (not shown) to fix permanently the cover 4 in the second position B. In this way, the cover 4 can be sealed in the second position B, once the cabling operations have been completed.

Preferably, the first coupling means are formed by a first holed protrusion 8, which raises perpendicularly to the outer surface 40 of the cover 4 at the second longitudinal edge 42 of this latter, while the second coupling means are formed by a second holed protrusion 28, which raises in parallel to the first wall 21 and perpendicularly to the second wall 22 at the common edge wall 20.

The first and second holed protrusions 8, 28 are configured to accommodate suitable fixing means (e,g, a lead seal connector) to seal the cover 4 in the second position B, when they are mutually coupled.

In the following, an example of practical use of the cover 4 is briefly described.

During cabling operations, the cover 4 is arranged in the first position A (figure 3). In this way, an operator can access the electric terminals 3 by means of a suitable tool (e.g. a screwdriver) that can be inserted through the access holes 23.

It is evidenced how, during the cabling operations, the cover 4 can be maintained in the first position A without any manual intervention of the operator thanks to the retaining action exerted by the mutually engaged first holding means 5 and second holding means 25.

Once the cabling operations have been completed, an operator can grasp manually the cover 4 (e.g. at the holed protrusion 8) and move rotationally it from the first position A to the intermediate position C by lifting the second longitudinal edge 42.

When the cover 4 has reached the intermediate position C (figure 4), the operator can move translationally the cover 4 along the second seat 220 by pushing it at the second longitudinal edge 42.

The cover 4 can thus reach the second position B (figure 5), at which the access holes 23 are fully obstructed and the electric terminals 3 are made inaccessible. At this stage, the cover 4 can be permanently fixed in the second position B by inserting a seal connector through the holed protrusions 8, 28 that couple together when the reaches the second position B.

It is evidenced how, during its rotation-translation movements, the cover 4 remains always mechanically coupled to the insulating housing 2 without the need of being hold manually by the operator.

It is further evidenced how, during the sealing operations, the cover 4 can be maintained in the second position B without any manual intervention of the operator thanks to the retaining action exerted by the mutually engaged first hinging means 6 and third holding means 27.

During possible maintenance interventions on the metering device 4, the cover 4 can be unsealed and then moved back from the second position B to the first position A with translation and rotation movements opposite to the movements described above.

In practice, it has been found that the metering device, according to the invention, fully achieves the intended aim and objects.

The metering device of the invention comprises, for each group of electric terminals, a terminal cover structurally integrated with the insulating housing of the metering device.

The one or more terminal covers of the metering device make easier the cabling and sealing operations of the corresponding groups of electric terminals without increasing the overall size of the metering device in any way.

The metering device of the invention has proven to be easy to industrially manufacture, at competitive costs compared to currently available metering devices of the state of the art.

## Claims

1. Metering device (1) for low-voltage electric systems comprising:
- an insulating housing (2) defining an internal volume of said metering device;
- one or more groups of electric terminals (3) accommodated in the internal volume of said metering device, each electric terminal being configured to be electrically and mechanically connected with a corresponding cable of an electric line;
wherein said insulating housing comprises, for at least a group of electric terminals, a group of cabling holes (24), each cabling hole being configured to form a passage for corresponding cables of an electric line,
wherein said insulating housing comprises, for at least a group of electric terminals, a first wall portion (21) and a second wall portion (22) mutually adjacent and unparallel one to another,
wherein, for at least a group of electric terminals, said insulating housing comprises, at said second wall portion (22), a group of access holes (23) configured to allow an access to corresponding electric terminals (3),
wherein said metering device (1) comprises, for at least a group of electric terminals, a movable cover (4) mechanically coupled to said insulating housing, wherein said cover is movable between a first position (A), at which said cover is located at said first wall portion (21), and a second position (B), at which said cover is located at said second wall portion (22),
wherein said cover obstructs said access holes (23), when it is in said second position (B),
**characterised in that** said cover (4) is accommodated in a first seat (210) of said first wall portion (21), when said cover is in said first position (A),
wherein said cover makes rotation and translation movements relative to said insulating housing (2), when said cover is moved between said first position (A) and said second position (B).

2. Metering device, according to claim 1, **characterised in that** said cover (4) passes through an intermediate position (C), when said cover (4) is moved between said first position (A) and said second position (B), wherein said cover makes a rotation movement, when said cover is moved between said first position (A) and said intermediate position (C), and makes a translation movement, when said cover is moved between said intermediate position (C) and said second position (B).

3. Metering device, according to one of the previous claims, **characterised in that** said cover (4) has an outer surface (40) coplanar with an outer surface (211) of said first wall portion (21), when said cover is accommodated in said first seat (210).

4. Metering device, according to one of the previous claims, **characterised in that** said cover (4) is inserted in a second seat (220) of said second wall portion (22), when said cover is in said second position (B).

5. Metering device, according to claim 4, **characterised in that** said cover (4) is buried in the internal volume defined by said insulating housing (2), when said cover is inserted in said second seat (220).

6. Metering device, according to one of the previous claims, **characterised in that** said cover (4) comprises first holding means (5) configured to interact mechanically with second holding means (25) of said insulating housing (2) to hold said cover (4) in said first position (A), wherein said first holding means (5) are configured to couple with said second holding means (25), when said cover (4) reaches said first position (A), and decouple from said second holding means (25), when said cover (4) is moved away from said first position (A).

7. Metering device, according to one of the claims from 2 to 6, **characterised in that** said cover (4) comprises first hinging means (6) configured to interact mechanically with second hinging means (26) of said insulating housing (2) to hinge said cover (4) to said insulating housing, when said cover (4) is moved rotationally between said first position (A) and said intermediate position (C), wherein said first hinging means (6) are configured to couple with said second hinging means (26), when said cover (4) is translationally moved away from said second position (B) and reaches said intermediate position (C), and decouple from said second hinging means (26), when said cover (4) is translationally moved away from said intermediate position (C) towards said second position (B).

8. Metering device, according to claim 7, **characterised in that** said first hinging means (6) are configured to interact mechanically with third holding means (27) of said insulating housing (2) to hold said cover (4) in said second position (B), wherein said first hinging means (6) are configured to couple with said third holding means (27), when said cover (4) reaches said second position (B), and decouple from said third holding means (27), when said cover (4) is moved away from said second position (B).

9. Metering device, according to one of the previous claims, **characterised in that** said cover (4) comprises first coupling means (8) configured to couple with second coupling means (28) of said insulating housing, when said cover (4) is in said second position (B), wherein said first and second coupling means (8, 28) are configured to cooperate mechanically with fixing means to seal said cover (4) in said second position (B), when said cover (4) is in said second position (B).

10. Metering device, according to one of the previous claims, **characterised in that** it is an energy meter.

## Patentansprüche

1. Messvorrichtung (1) für elektrische Niederspannungssysteme, Folgendes umfassend:
- ein isolierendes Gehäuse (2), das ein Innenvolumen der Messvorrichtung definiert;
- eine oder mehrere Gruppen elektrischer Anschlüsse (3), die in dem Innenvolumen der Messvorrichtung untergebracht sind, wobei jeder elektrische Anschluss dazu ausgelegt ist, elektrisch und mechanisch mit einem entsprechenden Kabel einer elektrischen Leitung verbunden zu sein;
wobei das isolierende Gehäuse für mindestens eine Gruppe elektrischer Anschlüsse eine Gruppe von Kabelöffnungen (24) umfasst, wobei jede Kabelöffnung dazu ausgelegt ist, einen Durchlass für entsprechende Kabel einer elektrischen Leitung zu bilden,
wobei das isolierende Gehäuse für mindestens eine Gruppe elektrischer Anschlüsse einen ersten Wandabschnitt (21) und einen zweiten Wandabschnitt (22) umfasst, die aneinander angrenzen und nicht parallel zueinander liegen,
wobei das isolierende Gehäuse für mindestens eine Gruppe elektrischer Anschlüsse an dem zweiten Wandabschnitt (22) eine Gruppe von Zugangsöffnungen (23) umfasst, die dazu ausgelegt sind, einen Zugang zu entsprechenden elektrischen Anschlüssen (3) zu gewähren,
wobei die Messvorrichtung (1) für mindestens eine Gruppe elektrischer Anschlüsse eine bewegliche Abdeckung (4) umfasst, die mechanisch mit dem isolierenden Gehäuse gekoppelt ist, wobei die Abdeckung zwischen einer ersten Position (A), an der sich die Abdeckung an dem ersten Wandabschnitt (21) befindet, und einer zweiten Position (B), an der sich die Abdeckung an dem zweiten Wandabschnitt (22) befindet, beweglich ist,
wobei die Abdeckung die Zugangsöffnungen (23) verdeckt, wenn sie sich in der zweiten Position (B) befindet, **dadurch gekennzeichnet, dass** die Abdeckung (4) in einem ersten Sitz (210) des ersten Wandabschnitts (21) untergebracht ist, wenn sich die Abdeckung in der ersten Position (A) befindet,
wobei die Abdeckung Dreh- und Verschiebungsbewegungen relativ zu dem isolierenden Gehäuse (2) absolviert, wenn die Abdeckung zwischen der ersten Position (A) und der zweiten Position (B) bewegt wird.

2. Messvorrichtung nach Anspruch 1, **dadurch gekennzeichnet, dass** die Abdeckung (4) eine Zwischenposition (C) durchläuft, wenn die Abdeckung (4) zwischen der ersten Position (A) und der zweiten Position (B) bewegt wird, wobei die Abdeckung eine Drehbewegung absolviert, wenn die Abdeckung zwischen der ersten Position (A) und der Zwischenposition (C) bewegt wird, und eine Verschiebungsbewegung absolviert, wenn die Abdeckung zwischen der Zwischenposition (C) und der zweiten Position (B) bewegt wird.

3. Messvorrichtung nach einem der vorhergehenden Ansprüche, **dadurch gekennzeichnet, dass** die Abdeckung (4) eine Außenfläche (40) aufweist, die koplanar mit einer Außenfläche (211) des ersten Wandabschnitts (21) liegt, wenn die Abdeckung in dem ersten Sitz (210) untergebracht ist.

4. Messvorrichtung nach einem der vorhergehenden Ansprüche, **dadurch gekennzeichnet, dass** die Abdeckung (4) in einen zweiten Sitz (220) des zweiten Wandabschnitts (22) eingesetzt ist, wenn sich die Abdeckung in der zweiten Position (B) befindet.

5. Messvorrichtung nach Anspruch 4, **dadurch gekennzeichnet, dass** die Abdeckung (4) in dem durch das isolierende Gehäuse (2) definierte Innenvolumen eingelassen ist, wenn die Abdeckung in den zweiten Sitz (220) eingesetzt ist.

6. Messvorrichtung nach einem der vorhergehenden Ansprüche, **dadurch gekennzeichnet, dass** die Abdeckung (4) erste Haltemittel (5) umfasst, die dazu ausgelegt sind, mechanisch mit zweiten Haltemitteln (25) des isolierenden Gehäuses (2) zu interagieren, um die Abdeckung (4) in der ersten Position (A) zu halten, wobei die ersten Haltemittel (5) dazu ausgelegt sind, sich mit den zweiten Haltemitteln (25) zu koppeln, wenn die Abdeckung (4) die erste Position (A) erreicht, und sich von den zweiten Haltemitteln (25) zu entkoppeln, wenn die Abdeckung (4) von der ersten Position (A) weg bewegt wird.

7. Messvorrichtung nach einem der Ansprüche 2 bis 6, **dadurch gekennzeichnet, dass** die Abdeckung (4) erste Gelenkmittel (6) umfasst, die dazu ausgelegt sind, mechanisch mit zweiten Gelenkmitteln (26) des isolierenden Gehäuses (2) zu interagieren, um die Abdeckung (4) an das isolierende Gehäuse anzulenken, wenn die Abdeckung (4) drehend zwischen der ersten Position (A) und der Zwischenposition (C) bewegt wird, wobei die ersten Gelenkmittel (6) dazu ausgelegt sind, sich mit den zweiten Gelenkmitteln (26) zu koppeln, wenn die Abdeckung (4) translatorisch weg von der zweiten Position (B) bewegt wird und die Zwischenposition (C) erreicht, und sich von den zweiten Gelenkmitteln (26) zu entkoppeln, wenn die Abdeckung (4) translatorisch weg von der Zwischenposition (C) hin zu der zweiten Position (B) bewegt wird.

8. Messvorrichtung nach Anspruch 7, **dadurch gekennzeichnet, dass** die ersten Gelenkmittel (6) dazu ausgelegt sind, mechanisch mit dritten Haltemitteln (27) des isolierenden Gehäuses (2) zu interagieren, um die Abdeckung (4) in der zweiten Position (B) zu halten, wobei die ersten Gelenkmittel (6) dazu ausgelegt sind, sich mit den dritten Haltemitteln (27) zu koppeln, wenn die Abdeckung (4) die zweite Position (B) erreicht und sich von den dritten Haltemitteln (27) zu entkoppeln, wenn die Abdeckung (4) von der zweiten Position (B) weg bewegt wird.

9. Messvorrichtung nach einem der vorhergehenden Ansprüche, **dadurch gekennzeichnet, dass** die Abdeckung (4) erste Kopplungsmittel (8) umfasst, die dazu ausgelegt sind, sich mit zweiten Kopplungsmitteln (28) des isolierenden Gehäuses zu koppeln, wenn sich die Abdeckung (4) in der zweiten Position (B) befindet, wobei die ersten und die zweiten Kopplungsmittel (8, 28) dazu ausgelegt sind, mechanisch mit Fixierungsmitteln zusammenzuwirken, um die Abdeckung (4) in der zweiten Position (B) zu sperren, wenn sich die Abdeckung (4) in der zweiten Position (B) befindet.

10. Messvorrichtung nach einem der vorhergehenden Ansprüche, **dadurch gekennzeichnet, dass** sie ein Energiezähler ist.

## Revendications

1. Dispositif de mesure (1) pour systèmes électriques basse tension comprenant :
- un boîtier isolant (2) définissant un volume interne dudit dispositif de mesure ;
- un ou plusieurs groupes de bornes électriques (3) logées dans le volume interne dudit dispositif de mesure, chaque borne électrique étant conçue pour être connectée électriquement et mécaniquement à un câble correspondant d'une ligne électrique ;
ledit boîtier isolant comprenant, pour au moins un groupe de bornes électriques, un groupe de trous de câblage (24), chaque trou de câblage étant conçu pour former un passage pour les câbles correspondants d'une ligne électrique,
ledit boîtier isolant comprenant, pour au moins un groupe de bornes électriques, une première partie de paroi (21) et une seconde partie de paroi (22) mutuellement adjacentes et non parallèles l'une à l'autre,
pour au moins un groupe de bornes électriques, ledit boîtier isolant comprenant, au niveau de ladite seconde partie de paroi (22), un groupe de trous d'accès (23) conçus pour permettre un accès aux bornes électriques (3) correspondantes,
ledit dispositif de mesure (1) comprenant, pour au moins un groupe de bornes électriques, un couvercle mobile (4) accouplé mécaniquement audit boîtier isolant, ledit couvercle étant mobile entre une première position (A), dans laquelle ledit couvercle est situé au niveau de ladite première partie de paroi (21), et une seconde position (B), dans laquelle ledit couvercle est situé au niveau de ladite seconde partie de paroi (22),
ledit couvercle obstruant lesdits trous d'accès (23), lorsqu'il est dans ladite seconde position (B), **caractérisé en ce que** ledit couvercle (4) est logé dans un premier siège (210) de ladite première partie de paroi (21), lorsque ledit couvercle est dans ladite première position (A),
ledit couvercle effectuant des mouvements de rotation et de translation par rapport audit boîtier isolant (2), lorsque ledit couvercle est déplacé entre ladite première position (A) et ladite seconde position (B).

2. Dispositif de mesure selon la revendication 1, **caractérisé en ce que** ledit couvercle (4) passe par une position intermédiaire (C), lorsque ledit couvercle (4) est déplacé entre ladite première position (A) et ladite seconde position (B), ledit couvercle effectuant un mouvement de rotation, lorsque ledit couvercle est déplacé entre ladite première position (A) et ladite position intermédiaire (C), et effectuant un mouvement de translation, lorsque ledit couvercle est déplacé entre ladite position intermédiaire (C) et ladite seconde position (B).

3. Dispositif de mesure selon l'une des revendications précédentes, **caractérisé en ce que** ledit couvercle (4) a une surface extérieure (40) coplanaire avec une surface extérieure (211) de ladite première partie de paroi (21), lorsque ledit couvercle est logé dans ledit premier siège (210).

4. Dispositif de mesure selon l'une des revendications précédentes, **caractérisé en ce que** ledit couvercle (4) est inséré dans un second siège (220) de ladite seconde partie de paroi (22), lorsque ledit couvercle est dans ladite seconde position (B).

5. Dispositif de mesure selon la revendication 4, **caractérisé en ce que** ledit couvercle (4) est noyé dans le volume interne défini par ledit boîtier isolant (2), lorsque ledit couvercle est inséré dans ledit second siège (220).

6. Dispositif de mesure selon l'une des revendications précédentes, **caractérisé en ce que** ledit couvercle (4) comprend un premier moyen de maintien (5) conçu pour interagir mécaniquement avec un deuxième moyen de maintien (25) dudit logement isolant (2) pour maintenir ledit couvercle (4) dans ladite première position (A), ledit premier moyen de maintien (5) étant conçu pour s'accoupler audit deuxième moyen de maintien (25), lorsque ledit couvercle (4) atteint ladite première position (A), et se séparer dudit deuxième moyen de maintien (25), lorsque ledit couvercle (4) est déplacé à l'opposé de ladite première position (A).

7. Dispositif de mesure selon l'une des revendications 2 à 6, **caractérisé en ce que** ledit couvercle (4) comprend un premier moyen d'articulation (6) conçu pour interagir mécaniquement avec un second moyen d'articulation (26) dudit logement isolant (2) pour articuler ledit couvercle (4) sur ledit logement isolant, lorsque ledit couvercle (4) est déplacé en rotation entre ladite première position (A) et ladite position intermédiaire (C), ledit premier moyen d'articulation (6) étant conçu pour s'accoupler avec ledit second moyen d'articulation (26), lorsque ledit couvercle (4) est déplacé par translation à l'opposé de ladite seconde position (B) et atteint ladite position intermédiaire (C), et se séparer dudit second moyen d'articulation (26), lorsque ledit couvercle (4) est déplacé par translation à l'opposé de ladite position intermédiaire (C) vers ladite seconde position (B).

8. Dispositif de mesure selon la revendication 7, **caractérisé en ce que** ledit premier moyen d'articulation (6) est conçu pour interagir mécaniquement avec un troisième moyen de maintien (27) dudit logement isolant (2) pour maintenir ledit couvercle (4) dans ladite seconde position (B), ledit premier moyen d'articulation (6) étant conçu pour s'accoupler avec ledit troisième moyen de maintien (27), lorsque ledit couvercle (4) atteint ladite seconde position (B), et se séparer dudit troisième moyen de maintien (27), lorsque ledit couvercle (4) est déplacé à l'opposé de ladite seconde position (B).

9. Dispositif de mesure selon l'une des revendications précédentes, **caractérisé en ce que** ledit couvercle (4) comprend un premier moyen d'accouplement (8) conçu pour s'accoupler avec un second moyen d'accouplement (28) dudit logement isolant, lorsque ledit couvercle (4) est dans ladite seconde position (B), lesdits premier et second moyens d'accouplement (8, 28) étant conçus pour coopérer mécaniquement avec un moyen de fixation pour sceller ledit couvercle (4) dans ladite seconde position (B), lorsque ledit couvercle (4) est dans ladite seconde position (B).

10. Dispositif de mesure selon l'une des revendications précédentes, **caractérisé en ce qu'**il s'agit d'un compteur d'énergie.
